# EUROPEAN PATENT APPLICATION

(11) **EP 3 457 447 A1**
(43) Date of publication of application: **20.03.2019**
(21) Application number: 18158469.9
(22) Date of filing: 23.02.2018
(51) Int. Cl.: H01L 51/42, H01L 27/30, G01T 1/20

(54) **PHOTOELECTRIC CONVERSION ELEMENT AND RADIATION DETECTOR**

(30) Priority: 15.09.2017 JP 2017178307
(71) Applicant: KABUSHIKI KAISHA TOSHIBA, Minato-ku Tokyo 105-8001 (JP)
(72) Inventor: TAGUCHI, Satomi, Tokyo, 105-8001 (JP); AIGA, Fumihiko, Tokyo, 105-8001 (JP); WADA, Atsushi, Tokyo, 105-8001 (JP); TAKASU, Isao, Tokyo, 105-8001 (JP); HASEGAWA, Rei, Tokyo, 105-8001 (JP)
(74) Representative: Moreland, David

(57) **Abstract**

According to one embodiment, a photoelectric conversion element (110, 120) includes a first conductive layer (10), a second conductive layer (20), an organic semiconductor layer (30), and a first region (40). The first conductive layer (10) includes a first metal (11). The organic semiconductor layer (30) is provided between the first conductive layer (10) and the second conductive layer (20). The first region (40) includes the first metal (11) and oxygen and is positioned between the organic semiconductor layer (30) and the first conductive layer (10).

## Description

### FIELD

Embodiments described herein relate generally to a photoelectric conversion element and a radiation detector.

### BACKGROUND

For example, there is a photoelectric conversion element that uses an organic semiconductor material. There is an imaging element that uses the photoelectric conversion element. There is a radiation detector that uses the photoelectric conversion element. It is desirable to increase the sensitivity of the photoelectric conversion element.

### BRIEF DESCRIPTION OF THE DRAWINGS

FIG. 1 is a schematic view illustrating a photoelectric conversion element according to a first embodiment;
FIG. 2A and FIG. 2B are schematic views illustrating a portion of the photoelectric conversion element according to the first embodiment;
FIG. 3 is a graph illustrating a characteristic of the photoelectric conversion element;
FIG. 4 is a graph illustrating analysis results of the photoelectric conversion element;
FIG. 5 is a schematic view illustrating an operation of the photoelectric conversion element according to the first embodiment;
FIG. 6 is a graph illustrating evaluation results of the photoelectric conversion element;
FIG. 7 is a schematic view illustrating another photoelectric conversion element according to the first embodiment;
FIG. 8 is a schematic view illustrating a radiation detector according to a second embodiment;
FIG. 9 is a schematic view illustrating another radiation detector according to the second embodiment;
FIG. 10 is a schematic view illustrating another radiation detector according to the second embodiment; and
FIG. 11 is a schematic view illustrating an imaging device according to a third embodiment.

### DETAILED DESCRIPTION

According to one embodiment, a photoelectric conversion element includes a first conductive layer, a second conductive layer, an organic semiconductor layer, and a first region. The first conductive layer includes a first metal. The organic semiconductor layer is provided between the first conductive layer and the second conductive layer. The first region includes the first metal and oxygen and is positioned between the organic semiconductor layer and the first conductive layer.

According to another embodiment, a radiation detector includes the photoelectric conversion element described above and a scintillator layer. A direction from the scintillator layer toward the organic semiconductor layer is aligned with a first direction from the second conductive layer toward the first conductive layer.

According to another embodiment, a radiation detector includes a plurality of the photoelectric conversion elements described above and a detection circuit electrically connected to the first conductive layer and the second conductive layer. The detection circuit outputs a signal corresponding to an intensity of radiation incident on at least a portion of a stacked body of the plurality of photoelectric conversion elements. The stacked body includes the first conductive layer, the second conductive layer, the organic semiconductor layer, and the first region.

Various embodiments will be described hereinafter with reference to the accompanying drawings.

The drawings are schematic and conceptual; and the relationships between the thickness and width of portions, the proportions of sizes among portions, etc., are not necessarily the same as the actual values thereof. Further, the dimensions and proportions may be illustrated differently among drawings, even for identical portions.

In the specification and drawings, components similar to those described or illustrated in a drawing thereinabove are marked with like reference numerals, and a detailed description is omitted as appropriate.

### First embodiment

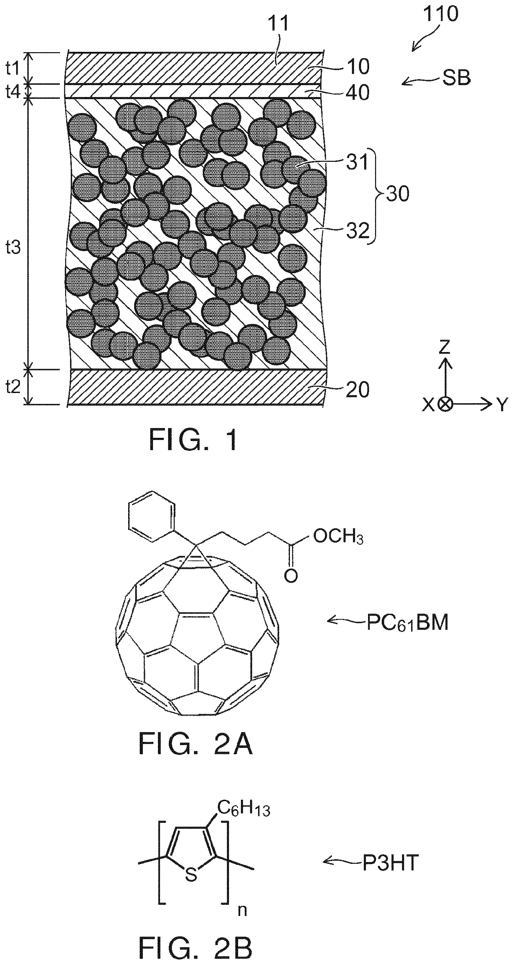

FIG. 1 is a schematic view illustrating a photoelectric conversion element according to a first embodiment.

As shown in FIG. 1, the photoelectric conversion element 110 according to the embodiment includes a first conductive layer 10, a second conductive layer 20, an organic semiconductor layer 30, and a first region 40. The organic semiconductor layer 30 is positioned between the first conductive layer 10 and the second conductive layer 20. The first region 40 is provided between the organic semiconductor layer 30 and the first conductive layer 10.

A first direction from the second conductive layer 20 toward the first conductive layer 10 is taken as a Z-axis direction. One direction perpendicular to the Z-axis direction is taken as an X-axis direction. A direction perpendicular to the Z-axis direction and the X-axis direction is taken as a Y-axis direction.

The first conductive layer 10 and the second conductive layer 20 spread along the X-Y plane.

The first conductive layer 10 includes a first metal 11. For example, the first metal 11 includes nickel.

The first region 40 includes the first metal 11 and oxygen.

In one example, the organic semiconductor layer 30 includes a first compound 31 of a first conductivity type, and a second compound 32 of a second conductivity type. For example, the first compound 31 is included in a semiconductor region of the first conductivity type. For example, the second compound 32 is included in a semiconductor region of the second conductivity type. The first conductivity type is one of an n-type or a p-type. The second conductivity type is the other of the n-type or the p-type. Hereinbelow, the first conductivity type is the n-type; and the second conductivity type is the p-type.

The first region 40 may include, for example, at least one of the first compound 31 or the second compound 32.

Thus, the photoelectric conversion element 110 includes a stacked body SB. The stacked body SB includes the first conductive layer 10, the second conductive layer 20, the organic semiconductor layer 30, and the first region 40.

A thickness t1 of the first conductive layer 10 is, for example, not less than 10 nanometers (nm) and not more than 1000 nm. A thickness t2 of the second conductive layer 20 is, for example, not less than 10 nm and not more than 1000 nm. A thickness t3 of the organic semiconductor layer 30 is, for example, not less than 10 µm and not more than 500 µm. The thickness t3 may be, for example, 200 µm or less. A thickness t4 of the first region 40 is, for example, not less than 2 nm and not more than 100 nm. The thickness t4 may be, for example, 5 nm or more. The thickness t4 may be, for example, 10 nm or more. The thickness t4 may be 50 nm or less. These thicknesses are lengths along the Z-axis direction.

In one example of the organic semiconductor layer 30, the first compound 31 includes, for example, fullerene. The second compound 32 includes, for example, polythiophene. For example, the first compound 31 includes PC₆₁BM ([6,6]-phenyl C61 butyric acid methyl ester). For example, the second compound 32 includes P3HT (poly(3-hexylthiophene)).

FIG. 2A and FIG. 2B are schematic views illustrating a portion of the photoelectric conversion element according to the first embodiment.

FIG. 2A shows PC₆₁BM as an example of the first compound 31. FIG. 2B shows P3HT as an example of the second compound 32.

As described above, the first region 40 includes the first metal 11 and oxygen. It was found that a high conversion efficiency is obtained by providing such a first region 40. The conversion efficiency is, for example, the external quantum efficiency.

An example of evaluation results of characteristics of the photoelectric conversion element will now be described.

A first sample that is evaluated has the following configuration. ITO (Indium Tin Oxide) is used as the second conductive layer 20. The thickness t2 of the second conductive layer 20 is 50 µm. In the organic semiconductor layer 30, PC₆₁BM is used as the first compound 31; and P3HT is used as the second compound 32. The mole ratio of the first compound 31 and the second compound 32 is 1:1. The thickness t3 of the organic semiconductor layer 30 is 50 µm. A nickel (Ni) film is used as the first conductive layer 10. The thickness t1 of the first conductive layer 10 is 200 nm.

In the first sample, the organic semiconductor layer 30 is formed on the second conductive layer 20; and the first conductive layer 10 is formed on the organic semiconductor layer 30. Subsequently, annealing is performed for 10 minutes at 140 °C.

On the other hand, in a second sample, an aluminum (Al) film is used as the first conductive layer 10. Otherwise, the configuration of the second sample is the same as that of the first sample.

On the other hand, in a third sample, an NBphen (2,9-Bis(naphthalen-2-yl)-4,7-diphenyl-1,10-phenanthroline) layer is provided between the organic semiconductor layer 30 and the first conductive layer 10. The thickness of the NBphen-layer is 30 nm. The NBphen-layer functions as a hole-blocking layer. Otherwise, the configuration of the third sample is the same as that of the first sample.

In these samples, a bias voltage is applied between the first conductive layer 10 and the second conductive layer 20. The external quantum efficiency when light is irradiated on each of these samples is evaluated.

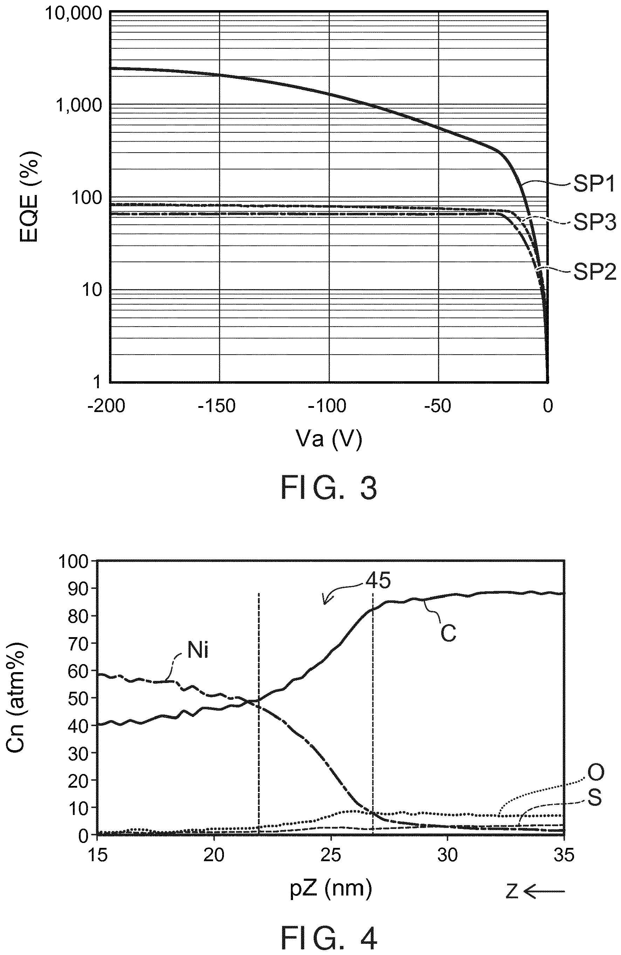

FIG. 3 is a graph illustrating a characteristic of the photoelectric conversion element.

The horizontal axis of FIG. 3 is a bias voltage Va (V). The vertical axis is an external quantum efficiency EQE (%). The characteristics of the first sample SP1, the second sample SP2, and the third sample SP3 are shown in FIG. 3.

It can be seen from FIG. 3 that the external quantum efficiency EQE is low for the second sample SP2 and the third sample SP3. Conversely, the external quantum efficiency EQE is extremely high for the first sample SP1.

From the comparison between the first sample SP1 and the second sample SP2, it is considered that the difference between the materials of the first conductive layer 10 affects the external quantum efficiency EQE. From the comparison between the first sample SP1 and the third sample SP3, it is considered that the state of the first conductive layer 10 and the organic semiconductor layer 30 being in physical contact affects the external quantum efficiency EQE.

FIG. 4 is a graph illustrating analysis results of the photoelectric conversion element.

FIG. 4 shows the analysis results using EDX (Energy Dispersive X-ray Spectroscopy) of the first sample SP1. The vertical axis is a concentration Cn (atomic percent (atm%)) of the elements. The horizontal axis is a position pZ along the Z-axis direction. The analysis results are shown in FIG. 4 for a region including the first conductive layer 10 and the organic semiconductor layer 30. The region where the position pZ is greater than 27 nm corresponds to the organic semiconductor layer 30. It is considered that the region where the position pZ is less than 15 nm corresponds to the first conductive layer 10.

As shown in FIG. 4, in the region where the position pZ is greater than 27 nm, the concentration of C (carbon), the concentration of O (oxygen), and the concentration of S (sulfur) are high. It is considered that these elements originate in the P3HT and the PC₆₁BM included in the organic semiconductor layer 30.

Ni and C exist in the region where the position pZ is not less than 20 nm and not more than 27 nm. O exists in a region 45 where the position pZ is not less than 22 nm and not more than 27 nm. S exists in the region where the position pZ is not less than 24 nm and not more than 27 nm. It is considered that the region 45 where the position pZ is not less than 22 nm and not more than 27 nm is a region where the first conductive layer 10 and the oxygen mix. The region 45 where the first conductive layer 10 and the oxygen mix corresponds to the first region 40. It is considered that the C (carbon) existing in the region where the position pZ is not less than 20 nm and not more than 27 nm originates in hydrocarbons mixing when preparing the thin-section sample, in the apparatus of the observation, etc.

Thus, in the first sample SP1, a region (the first region 40) exists where it is considered that the first conductive layer 10 and the oxygen mix. In the first region 40, both oxygen and the first metal 11 (in the example recited above, Ni) included in the first conductive layer 10 exist. It is considered that the high external quantum efficiency EQE is obtained in the first sample SP1 due to such a special configuration (the first region 40).

For example, in the third sample SP3, the NBphen-layer (the hole-blocking layer) is provided between the organic semiconductor layer 30 and the first conductive layer 10. Therefore, in the third sample SP3, the distance is distal between the first conductive layer 10 and the organic semiconductor layer 30. Therefore, in the third sample SP3, it is considered that a region is not formed easily where both the first metal 11 (in the example recited above, Ni) and the materials included in the organic semiconductor layer 30 exist.

For example, in the second sample SP2, the first metal 11 of the first conductive layer 10 is Al. In the case where Al is oxidized, an insulator is formed; but Ni when oxidized forms a semiconductor and forms a trap level.

For example, light 81 is incident on the organic semiconductor layer 30 via the second conductive layer 20. Thereby, movable electrons are generated in the organic semiconductor layer 30. The bias voltage Va is applied between the first conductive layer 10 and the second conductive layer 20. Thereby, the electrons move toward the first conductive layer 10. At this time, the electrons are affected by the trap level formed in the first region 40. For example, the generated electrons are multiplied by the bias voltage Va. On the other hand, hole injection occurs from the first conductive layer 10 toward the first region 40. The holes can pass through the first region 40 and the organic semiconductor layer 30 from the first conductive layer 10 and move toward the second conductive layer 20.

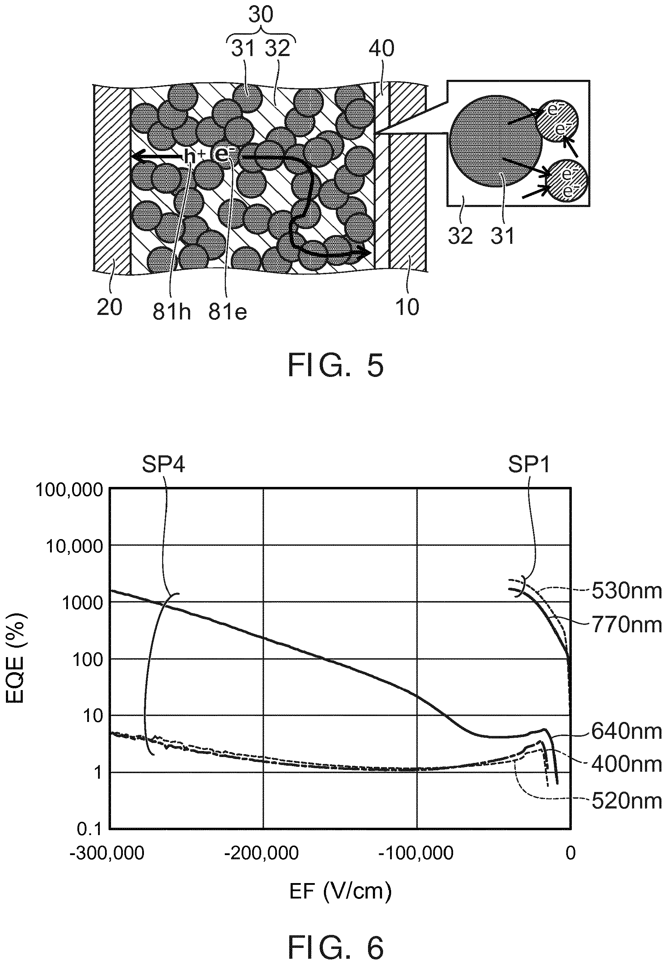

FIG. 5 is a schematic view illustrating an operation of the photoelectric conversion element according to the first embodiment.

As shown in FIG. 5, it is considered that movable electrons 81e that are generated in the organic semiconductor layer 30 pass through mainly paths due to the first compound 31 (e.g., PC₆₁BM) and enter the first region 40. In the first region 40, it is considered that the electrons 81e reach the oxide of Ni. For example, it is considered that the oxide of Ni becomes traps for the electrons 81e. It is considered that the electrons 81e that reach the traps move toward the first conductive layer 10 due to the bias voltage Va. The electrons 81e that correspond to the intensity of the light are detected with a high multiplication factor. In the organic semiconductor layer 30, it is considered that, for example, holes 81h pass through paths due to the second compound 32 and move toward the second conductive layer 20.

Separation of the charge occurs easily in the first sample SP1 having such a configuration. The mobility of the electrons 81e is high. Therefore, a high multiplication factor is obtained even in the case where the bias voltage Va (the bias electric field) is low.

FIG. 6 is a graph illustrating evaluation results of the photoelectric conversion element.

In FIG. 6, the characteristic of a fourth sample SP4 recited below is shown in addition to the characteristic of the first sample SP1 recited above. In the organic semiconductor layer 30 of the fourth sample SP4 as well, PC₇₁BM is used as the first compound 31; and P3HT is used as the second compound 32. The mole ratio of the first compound 31 and the second compound 32 is 100:1. The thickness t3 of the organic semiconductor layer 30 is 3.4 µm. An Al film is used as the first conductive layer 10. The thickness t1 of the first conductive layer 10 is 100 µm. In the fourth sample SP4, a BCP layer is provided between the organic semiconductor layer 30 and the first conductive layer 10. The thickness of the BCP layer is 5 nm. Otherwise, the configuration of the fourth sample SP4 is the same as the configuration of the first sample SP1.

The horizontal axis of FIG. 6 is an electric field intensity EF (V/cm) between the first conductive layer 10 and the second conductive layer 20. The vertical axis is the external quantum efficiency EQE (%). In FIG. 6, the characteristics when the peak wavelength of the incident light is 530 nm and 770 nm are shown for the first sample SP1. The characteristics when the peak wavelength of the incident light is 400 nm, 520 nm, and 640 nm are shown for the fourth sample SP4.

As shown in FIG. 6, the external quantum efficiency EQE is much different between the wavelengths for the fourth sample SP4. When the wavelength is long (640 nm), the external quantum efficiency EQE is relatively high. When the wavelength is short (400 nm or 520 nm), the external quantum efficiency EQE is markedly low. For the fourth sample SP4, a high electric field intensity EF is necessary to obtain a high external quantum efficiency EQE.

Conversely, for the first sample SP1, a high external quantum efficiency EQE is obtained independent of the wavelength. A high external quantum efficiency EQE is obtained also for an extremely low electric field intensity EF.

Thus, in the embodiment, for example, the organic semiconductor layer 30 includes the first compound 31 of the first conductivity type and the second compound 32 of the second conductivity type. In such a case, the first region 40 includes the first metal 11 (e.g., nickel, etc.) and at least one of the first compound 31 or the second compound 32. In the case where the first compound 31 includes fullerene, the first region 40 includes fullerene. In the case where the first compound 31 includes PC₆₁BM, the first region 40 includes oxygen (referring to FIG. 4). In the case where the second compound 32 includes polythiophene, the first region 40 includes sulfur (referring to FIG. 4).

A high external quantum efficiency EQE is obtained by using such a configuration. A photoelectric conversion element can be provided in which it is possible to increase the sensitivity.

In the embodiment, the molar concentration of the first compound 31 in the organic semiconductor layer 30 is taken as a first molar concentration CM1. The molar concentration of the second compound 32 in the organic semiconductor layer 30 is taken as a second molar concentration CM2. The ratio *(CM1*/*CM2)* of the first molar concentration CM1 to the second molar concentration CM2 is, for example, not less than 0.25 and not more than 4. The charge mobility can be maintained by such molar concentrations.

The light transmittance of the second conductive layer 20 is higher than the light transmittance of the first conductive layer 10. The second conductive layer 20 is a transparent electrode. The second conductive layer 20 includes, for example, an oxide including at least one element selected from the group consisting of In, Sn, Zn, and Ti. The light can be incident on the organic semiconductor layer 30 with high efficiency via the second conductive layer 20. The second conductive layer 20 may include a thin metal film.

In the embodiment as described above, the thickness t3 of the organic semiconductor layer 30 is not less than 10 µm and not more than 500 µm. By such a thickness t3, for example, the noise can be suppressed.

For example, radiation may be incident on the organic semiconductor layer 30; and the intensity of the radiation may be detected. For example, light is generated by the radiation; and the light undergoes photoelectric conversion. Thereby, the radiation can be detected. For example, in the case where the thickness t3 of the organic semiconductor layer 30 is not less than 10 µm and not more than 500 µm, the radiation can be detected with high sensitivity while suppressing the noise.

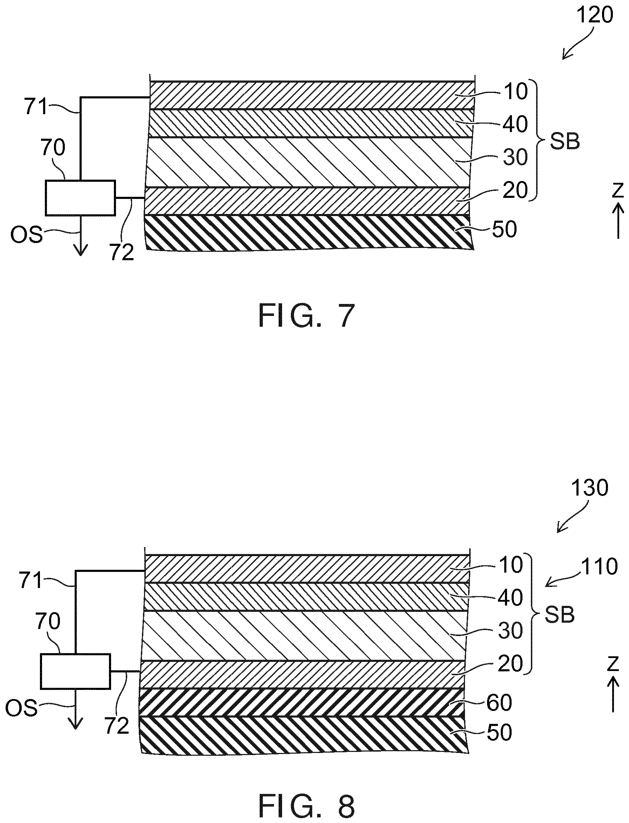

FIG. 7 is a schematic view illustrating another photoelectric conversion element according to the first embodiment.

As shown in FIG. 7, a substrate 50 is provided in the photoelectric conversion element 120. The second conductive layer 20 is provided between the substrate 50 and the first conductive layer 10.

A detection circuit 70 is provided in the example. The detection circuit 70 is electrically connected to the first conductive layer 10 and the second conductive layer 20. For example, the detection circuit 70 and the first conductive layer 10 are electrically connected by a first interconnect 71. For example, the detection circuit 70 and the second conductive layer 20 are electrically connected by a second interconnect 72. The detection circuit 70 outputs a signal OS corresponding to the intensity of the light incident on the stacked body SB.

### Second embodiment

The embodiment relates to a radiation detector.

FIG. 8 is a schematic view illustrating the radiation detector according to the second embodiment.

As shown in FIG. 8, the radiation detector 130 includes the photoelectric conversion element 110 and a scintillator layer 60. The direction from the scintillator layer 60 toward the organic semiconductor layer 30 is aligned with the first direction (the Z-axis direction) from the second conductive layer 20 toward the first conductive layer 10. For example, the second conductive layer 20 is positioned between the scintillator layer 60 and the organic semiconductor layer 30.

For example, light is generated in the scintillator layer 60 when the radiation is incident on the scintillator layer 60. The light is incident on the organic semiconductor layer 30; and photoelectric conversion is performed. The radiation can be detected by detecting the charge obtained by the photoelectric conversion. The radiation detector 130 is, for example, an indirect conversion radiation detector.

For example, the detection circuit 70 that is electrically connected to the first conductive layer 10 and the second conductive layer 20 is provided. The detection circuit 70 outputs the signal OS corresponding to the intensity of the radiation incident on at least a portion of the stacked body SB including the first conductive layer 10, the second conductive layer 20, the organic semiconductor layer 30, and the first region 40.

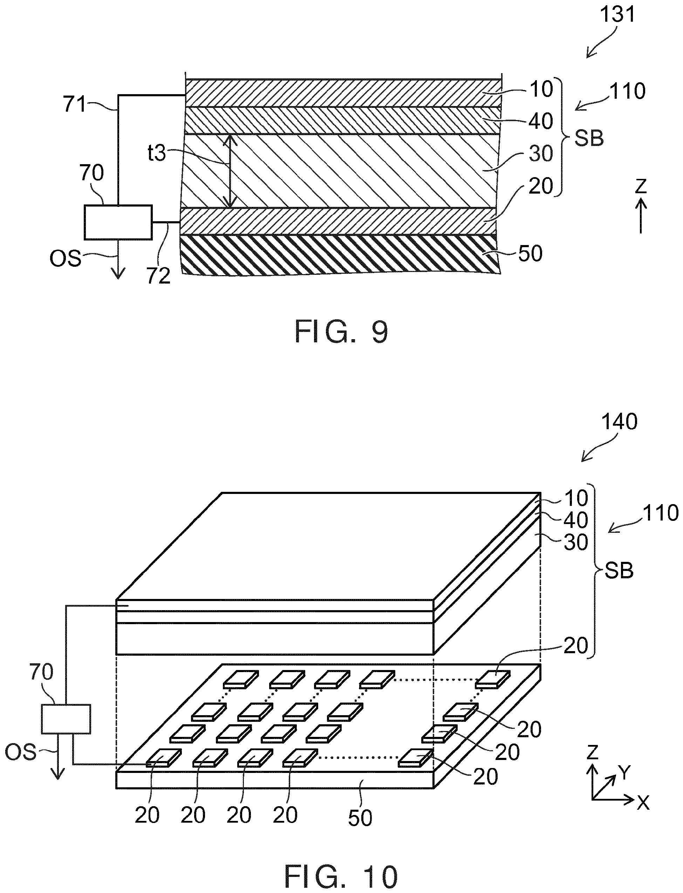

FIG. 9 is a schematic view illustrating another radiation detector according to the second embodiment.

As shown in FIG. 9, the radiation detector 131 includes the photoelectric conversion element 110 and the detection circuit 70. The scintillator layer 60 is not provided in the radiation detector 131. In the radiation detector 131, the radiation is incident on the organic semiconductor layer 30; light is generated in the organic semiconductor layer 30; and the light undergoes photoelectric conversion. The radiation detector 131 is a direct conversion radiation detector. In the radiation detector 131, it is favorable for the thickness t3 of the organic semiconductor layer 30 to be not less than 10 µm and not more than 500 µm. Thereby, the noise can be suppressed.

FIG. 10 is a schematic view illustrating another radiation detector according to the second embodiment.

As shown in FIG. 10, the radiation detector 140 includes the stacked bodies SB. The stacked bodies SB include the first conductive layer 10, the second conductive layers 20, the organic semiconductor layer 30, and the first region 40. The substrate 50 is provided in the example. In FIG. 10, some of the components included in the radiation detector 140 are drawn as being separated from each other for easier viewing of the drawing.

The second conductive layers 20 are multiply provided in the radiation detector 140. The multiple second conductive layers 20 are arranged along a plane (e.g., the X-Y plane) crossing the first direction (the Z-axis direction) from the second conductive layer 20 toward the first conductive layer 10. The X-Y plane is perpendicular to the Z-axis direction.

The multiple second conductive layers 20 are arranged along a second direction and a third direction along the plane (e.g., the X-Y plane); for example, the multiple second conductive layers 20 are arranged along the X-axis direction and the Y-axis direction. For example, the multiple second conductive layers 20 are arranged in a matrix configuration.

In the example, the first conductive layer 10, the organic semiconductor layer 30, and the first region 40 are provided to be continuous. For example, in the first direction (the Z-axis direction), the first conductive layer 10 overlaps a region between one of the multiple second conductive layers 20 and another one of the multiple second conductive layers 20. For example, in the first direction, the organic semiconductor layer 30 overlaps a region between one of the multiple second conductive layers 20 and another one of the multiple second conductive layers 20.

Each of the multiple second conductive layers 20 can be considered to be a portion of the photoelectric conversion elements. For example, the radiation detector 140 includes the multiple photoelectric conversion elements 110. The detection circuit 70 is electrically connected to the first conductive layer 10 and the second conductive layer 20. The detection circuit 70 outputs the signal OS corresponding to the intensity of the radiation incident on at least a portion of the stacked bodies SB of the multiple photoelectric conversion elements 110.

The scintillator layer 60 (referring to FIG. 8) may be further provided in the radiation detector 140.

### Third embodiment

The embodiment relates to an imaging device.

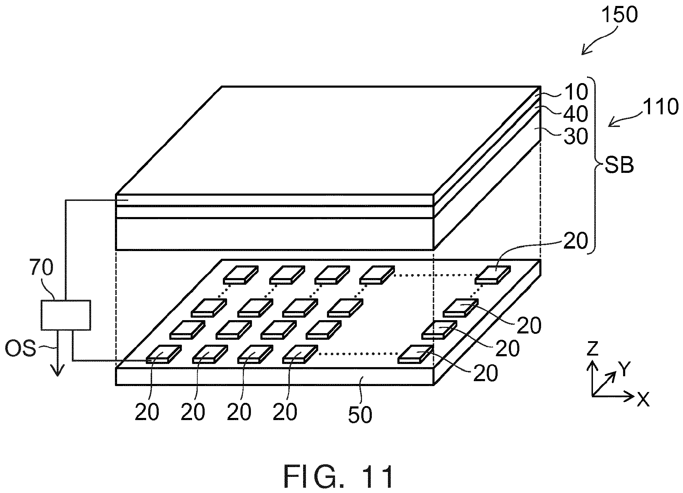

FIG. 11 is a schematic view illustrating the imaging device according to the third embodiment.

As shown in FIG. 11, the imaging device 150 includes the multiple photoelectric conversion elements 110. The multiple photoelectric conversion elements 110 are multiply provided along the X-Y plane. The detection circuit 70 is provided in the example. The detection circuit 70 is electrically connected to the multiple photoelectric conversion elements 110. The detection circuit 70 outputs the signal OS corresponding to the intensity of the light incident on at least a portion of the stacked bodies SB of the multiple photoelectric conversion elements including the first conductive layer 10, the second conductive layers 20, the organic semiconductor layer 30, and the first region 40.

For example, multiple first interconnects that extend in the X-axis direction and multiple second interconnects that extend in the Y-axis direction are provided. One of the multiple photoelectric conversion elements 110 is provided at each crossing portion of these interconnects. Each of the multiple photoelectric conversion elements 110 is selected by operations of switching elements, etc. The electrical signals that are obtained by the photoelectric conversion are detected by the detection circuit 70.

According to the embodiments, a photoelectric conversion element, an imaging device, and a radiation detector can be provided in which it is possible to increase the sensitivity.

In this specification, the "state of being electrically connected" includes the state in which multiple conductive bodies are physically in contact, and a current flows between the multiple conductive bodies. The "state of being electrically connected" includes the state in which another conductive body is inserted between multiple conductive bodies, and a current flows between the multiple conductive bodies.

In the specification of the application, "perpendicular" and "parallel" refer to not only strictly perpendicular and strictly parallel but also include, for example, the fluctuation due to manufacturing processes, etc. It is sufficient to be substantially perpendicular and substantially parallel.

Hereinabove, exemplary embodiments of the invention are described with reference to specific examples. However, the embodiments of the invention are not limited to these specific examples. For example, one skilled in the art may similarly practice the invention by appropriately selecting specific configurations of components included in photoelectric conversion elements, imaging devices, and radiation detectors such as conductive layers, organic semiconductors, first regions, etc., from known art. Such practice is included in the scope of the invention to the extent that similar effects thereto are obtained.

Further, any two or more components of the specific examples may be combined within the extent of technical feasibility and are included in the scope of the invention to the extent that the purport of the invention is included.

Moreover, all photoelectric conversion elements, imaging devices, and radiation detectors practicable by an appropriate design modification by one skilled in the art based on the photoelectric conversion elements, the imaging devices, and the radiation detectors described above as embodiments of the invention also are within the scope of the invention to the extent that the purport of the invention is included.

Various other variations and modifications can be conceived by those skilled in the art within the spirit of the invention, and it is understood that such variations and modifications are also encompassed within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A photoelectric conversion element (110, 120), comprising:
a first conductive layer (10) including a first metal (11);
a second conductive layer (20);
an organic semiconductor (30) layer provided between the first conductive layer (10) and the second conductive layer (20); and
a first region (40) including the first metal (11) and oxygen and being positioned between the organic semiconductor layer (30) and the first conductive layer (10).

2. The element (110, 120)according to claim 1, wherein
the organic semiconductor layer (30) includes:
a first compound (31) including fullerene; and
a second compound (32) including polythiophene.

3. The element (110, 120)according to claim 2, wherein the first region (40) includes sulfur.

4. The element (110, 120)according to one of claims 2 or 3, wherein the first region (40) includes fullerene.

5. The element (110, 120)according to one of claims 2-4, wherein the first compound (31) includes PC₆₁BM ([6,6]-phenyl C71 butyric acid methyl ester).

6. The element (110, 120)according to one of claims 2-5, wherein the second compound (32) includes P3HT (poly(3-hexylthiophene)).

7. The element (110, 120)according to one of claims 1-6, wherein the first metal (11) includes at least one selected from the group consisting of nickel, silver, and gold.

8. The element (110, 120)according to claim 1, wherein
the organic semiconductor layer (30) includes a first compound (31) of a first conductivity type, and a second compound (32) of a second conductivity type, and
a ratio of a first molar concentration of the first compound (31) in the organic semiconductor layer (30) to a second molar concentration of the second compound (32) in the organic semiconductor layer (30) is not less than 0.25 and not more than 4.

9. The element (110, 120)according to one of claims 1-8, wherein a thickness of the first region (40) is 2 nanometers or more.

10. The element (110, 120)according to one of claims 1-9, wherein the first metal (11) includes nickel.

11. The element (110, 120)according to one of claims 1-10, wherein a thickness of the organic semiconductor layer (30) is not less than 10 micrometers and not more than 500 micrometers.

12. The element (110, 120)according to one of claims 1-11, wherein a thickness of the organic semiconductor layer (30) is not less than 10 micrometers and not more than 200 micrometers.

13. The element (110, 120)according to one of claims 1-12, wherein a light transmittance of the second conductive layer (20) is higher than a light transmittance of the first conductive layer (10).

14. A radiation detector (130), comprising:
the photoelectric conversion element (110, 120) according to one of claims 1-13; and
a scintillator layer (60),
a direction from the scintillator layer (60) toward the organic semiconductor layer (30) being aligned with a first direction from the second conductive layer (20) toward the first conductive layer (10).

15. A radiation detector (140), comprising:
a plurality of the photoelectric conversion elements (110, 120) according to one of claims 1-13; and
a detection circuit (70) electrically connected to the first conductive layer (10) and the second conductive layer (20),
the detection circuit (70) outputting a signal corresponding to an intensity of radiation incident on at least a portion of a stacked body (SB) of the plurality of photoelectric conversion elements(110, 120), the stacked body (SB) including the first conductive layer (10), the second conductive layer (20), the organic semiconductor layer (30), and the first region (40).
